# EUROPEAN PATENT APPLICATION

(11) **EP 1 693 734 A1**
(43) Date of publication of application: **23.08.2006**
(21) Application number: 06110088.9
(22) Date of filing: 17.02.2006
(51) Int. Cl.: G06F 1/16

(54) **Mounting structure of cover plate and plasma display module including the same**

(30) Priority: 19.02.2005 KR 2005013891
(71) Applicant: Samsung SDI Co., Ltd., Suwon-si Gyeonggi-do (KR)
(72) Inventor: Ahn, Joong-Ha Samsung SDI Co., Ltd., Gyeonggi-do (KR); Kim, Dong-Hwan Samsung SDI Co., Ltd., Gyeonggi-do (KR)
(74) Representative: Hengelhaupt, Jürgen

(57) **Abstract**

A mounting structure of a cover plate using connection members to maintain a regular interval between the cover plate and a chassis, protect an integrated circuit chip, and effectively dissipate heat generated from the integrated circuit chip, and a plasma display module including the structure. The structure includes a chassis; an integrated circuit (IC) chip mounted on the chassis and connected to a signal transmission member; a cover plate facing the IC chip and protecting the signal transmission member and the IC chip; and a connection member having a center portion maintaining a constant distance between the cover plate and the chassis, a wing portion supporting the cover plate, and a head portion fixing the cover plate onto the chassis, and being forcibly inserted into the chassis.

## Description

### BACKGROUND OF THE INVENTION

### 1. Field of the Invention

Aspects of the present invention relate to a mounting structure of a cover plate and a plasma display module including the structure, and more particularly, to a mounting structure of a cover plate using connection members for maintaining a regular interval between the cover plate and a chassis, which can protect an integrated circuit chip and effectively dissipate heat generated from the integrated circuit chip, and a plasma display module including the structure.

### 2. Description of the Related Art

Plasma display panels (PDPs) that have begun to replace conventional cathode ray tubes (CRTs) are apparatuses for displaying images. In a PDP, a discharge gas is sealed between two substrates having a plurality of electrodes, a discharge gas is supplied to generate ultraviolet rays, and phosphor layers formed in a predetermined pattern are excited by the ultraviolet rays to emit visible light, and thus, an image is obtained.

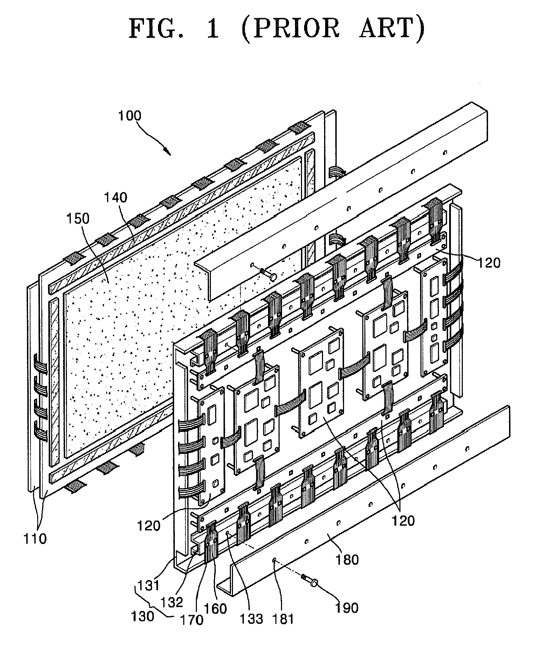

FIG. 1 is a perspective view of a plasma display module 100 used in a conventional plasma display apparatus. Referring to FIG. 1, the plasma display module 100 includes a plasma display panel 110, a plurality of circuit boards 120 on which circuits for driving the plasma display panel 110 are disposed, and a chassis 130 supporting the plasma display panel 110 and the circuit boards 120.

The plasma display module 100 is connected to the chassis 130 via a two-sided adhesive member 140 attached to a rear surface of the plasma display panel 110. A two-sided tape is used as the two-sided adhesive member 140.

A panel heat-dissipating sheet 150 having a good thermal conductivity is interposed between the plasma display panel 110 and the chassis 130 so that heat generated by the plasma display panel 110 during operation can be dissipated to the chassis 130.

The chassis 130 is generally formed of a metal such as aluminum, and includes a chassis base 131 and a reinforcing member 132.

The plasma display panel 110 is electrically connected to the circuit boards 120 through signal transmission members 160. The signal transmission members 160 are cables called a tape carrier package (TCP). A plurality of conducting wires extend in a direction in which the signal transmission members 160 are disposed. At least a portion of the conducting wires passes through integrated circuit (IC) chips 170.

The IC chips 170 are disposed on the reinforcing member 132 to which a cover plate 180 is connected to fix and protect the signal transmission members 160 and the IC chips 170.

A bolt 190 is used to connect the cover plate 180 to the reinforcing member 132. Holes 133 each having a nut are formed in the reinforcing member 132 at a regular interval. Perforate holes 181 through which the bolt 190 passes are formed in the cover plate 180 at a regular interval. Therefore, the bolt 190 is fixed onto the holes 133 through the perforate holes 181 so that the cover plate 180 can be mounted on the reinforcing member 132.

However, in a conventional mounting structure of the cover plate 180, it is difficult to maintain a constant engagement force of the bolt 190. Therefore, when the cover plate 180 is mounted on the reinforcing member 132, the bolt 190 may be over-tightened onto the cover plate 180, causing damage to the IC chips 170 or under-tightened onto the cover plate 180, making a large space between the IC chips 170 and the cover plate 180, which causes deterioration of heat-dissipating performance.

More specifically, in the conventional mounting structure of the cover plate 180, the bolt 190 and nuts are used to mount the cover plate 190 on the reinforcing member 132, making it difficult to appropriately control engagement force, so that the IC chips 170 are damaged or the heat-dissipating performance of the IC chips 170 is deteriorated.

Also, the plasma display panel 110 and the circuit boards 120 of the plasma display module 100 including the conventional mounting structure of the cover plate 180 generate vibration during operation. The vibration is transferred to the chassis 130, in particular to the reinforcing member 132 in which the cover plate 180 is mounted. Therefore, the bolt 190 may become loose due to continuous vibration resulting in the decrease of the engagement force of the bolt 190, and the deterioration of heat-dissipating performance of the IC chips 170 when the plasma display panel 100 is used for a long time.

### SUMMARY OF THE INVENTION

Aspects of the present invention provide a mounting structure of a cover plate using connection members for maintaining a regular interval between the cover plate and a chassis, which can protect an integrated circuit chip and effectively dissipate heat generated from the integrated circuit chip, and a plasma display module including the structure.

According to an aspect of the present invention, there is provided a mounting structure of the cover plate, the structure comprising: a chassis; an integrated circuit (IC) chip mounted on the chassis and connected to a signal transmission member; a cover plate facing the IC chip and protecting the signal transmission member and the IC chip; and a connection member comprising a center portion maintaining a constant distance between the cover plate and the chassis, a wing portion supporting the cover plate, and a head portion fixing the cover plate onto the chassis.

The signal transmission member may be a tape carrier package (TCP). The structure may further comprise a chip heat-dissipating sheet interposed between the IC chips and the cover plate. The head portion may comprise a tapered portion for fixing the cover plate. The head portion may comprise a projection for preventing the cover plate from separating from the chassis. The center portion, the wing portion, and the head portion of the connection member may be divided into a plurality of portions. The connection member may be forcibly inserted into the chassis, especially from a side of the chassis opposite the cover plate.

According to another aspect of the present invention, there is provided a plasma display module comprising: a plasma display panel displaying an image; a circuit board driving the plasma display panel; a chassis supporting the plasma display panel and the circuit board; a signal transmission member electrically connecting the circuit board to the plasma display panel; an IC chip mounted on the chassis and connected to the signal transmission member; a cover plate facing the IC chip and protecting the signal transmission member and the IC chip; and a connection member comprising a center portion maintaining a constant distance between the cover plate and the chassis, a wing portion supporting the cover plate, and a head portion fixing the cover plate to the chassis
The signal transmission member may be a TCP. The plasma display module may further comprise a chip heat-dissipating sheet interposed between the IC chip and the cover plate.
The head portion may comprise a tapered portion for fixing the cover plate. The head portion may comprise a projection for preventing the cover plate from separating from the chassis. The center portion, the wing portion, and the head portion of the connection member may be divided into a plurality of portions. The connection member may be forcibly inserted into the chassis, especially from a side of the chassis opposite the cover plate.

According to still another aspect of the invention there is provided a plasma display module comprising: a chassis; an IC chip mounted on the chassis; a cover plate disposed near the IC chip and conducting heat from the IC chip, the cover plate having an engagement hole; and a connector having a first end engaging the chassis and a second end, the second end comprising: a first tapered portion to guide the second end into the engagement hole, a wing portion to engagingly support the cover plate, and a second tapered portion to urge a side of the engagement hole toward the wing portion to maintain the cover plate at a predetermined distance from the chassis.

Preferably the first tapered portion comprises a plurality of tapered portions which elastically move in a first direction to guide the second end into the engagement hole. Preferably the second tapered portion comprises a plurality of tapered portions which elastically move in the first direction to guide the second end into the engagement hole and elastically move in a second direction opposite the first direction to urge the side of the engagement hole toward the wing portion. Preferably the plasma display module further comprises a dissipating sheet disposed between the IC chip and the cover plate to transfer heat from the IC chip to the cover plate.

Additional aspects and/or advantages of the invention will be set forth in part in the description which follows and, in part, will be obvious from the description, or may be learned by practice of the invention.

### BRIEF DESCRIPTION OF THE DRAWINGS

These and/or other aspects and advantages of the invention will become apparent and more readily appreciated from the following description of the embodiments, taken in conjunction with the accompanying drawings of which:
FIG. 1 is a perspective view of a plasma display module used in a conventional plasma display apparatus;
FIG. 2 is a schematic partially exploded perspective view of a mounting structure of a cover plate according to an embodiment of the present invention;
FIG. 3 is a cross-sectional view taken along line III-III of FIG. 2;
FIG. 4 is a perspective view of a connecting member before being forcibly inserted into a chassis according to an embodiment of the present invention; and
FIG. 5 is a schematic perspective view of a plasma display module including the mounting structure of the cover plate according to an embodiment of the present invention.

### DETAILED DESCRIPTION OF THE EMBODIMENTS

Reference will now be made in detail to the present embodiments of the present invention, examples of which are illustrated in the accompanying drawings, wherein like reference numerals refer to the like elements throughout. The embodiments are described below in order to explain the present invention by referring to the figures.

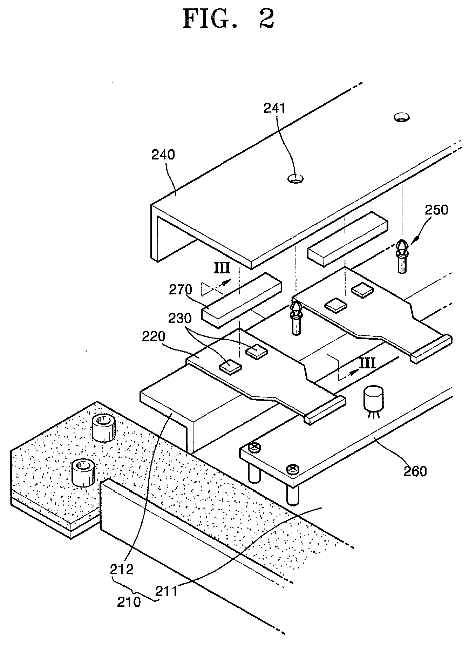

FIG. 2 is a schematic partially exploded perspective view of a mounting structure of a cover plate according to an embodiment of the present invention. Referring to FIG. 2, the mounting structure of the cover plate according to an embodiment of the present invention includes a chassis 210, signal transmission members 220, integrated circuit (IC) chips 230, the cover plate 240, and connection members 250.

The chassis 210 includes a chassis base 211 and a bending portion 212. The chassis base 211 is located in a center portion of the chassis 210. A circuit board 260 is mounted on the chassis base 211. The bending portion 212 is located on the corner of the chassis 210 and is bent to have a similar height as the height of the circuit board 260.

The signal transmission members 220 that transmit address signals pass over the bending portion 212. A tape carrier package (TCP) may be used as the signal transmission members 220.

The IC chips 230 are mounted on the bending portion 212. Thermal grease is interposed between the IC chips 230 and the bending portion 212. The IC chips 230 are connected to the signal transmission members 220 and control electrical signals.

The cover plate 240 is mounted on the bending portion 212 and protects the signal transmission members 220 and the IC chips 230.

Fixing holes 241 are formed in the cover plate 240 at predetermined intervals so that the cover plate 240 can be fixed onto the bending portion 212 with the connection members 250.

Chip heat-dissipating sheets 270 are interposed between the cover plate 240 and the IC chips 230, and dissipate heat generated by the IC chips 230 to the cover plate 240.

The chip heat-dissipating sheets 270 may be mounted on the IC chips 230 However, the heat-dissipating sheets 270 are not limited to mounting on the IC chips 230. That is, in the mounting structure of the cover plate 240, the IC chips 230 may be directly mounted on the cover plate 240 without the chip heat-dissipating sheets 270. In this case, heat generated by the IC chips 230 is directly dissipated to the cover plate 240.

The connection members 250 fix the cover plate 240 onto the bending portion 212, and a bottom portion of each connecting member 250 is forcibly inserted into the bending portion 212.

According to the embodiment of the present invention, the bending portion 212 extending from the chassis base 211 reinforces the rigidity of the chassis 210, and the IC chips 230 and the connection members 250 are mounted on the bending portion 212. However, the connection members 250 may be mounted in different ways. For example, in a structure such as the chassis 130 illustrated in FIG. 1 where the reinforcing member 132 is separately formed and is attached to the chassis base 211, thereby reinforcing the rigidity of the chassis 210, the IC chips 230 and the connection members 250 could be mounted on the reinforcing member 132. That is, there is no limitation to places where the IC chips 230, the connection members 250, and the cover plate 240 are mounted according to the current embodiment of the present invention.

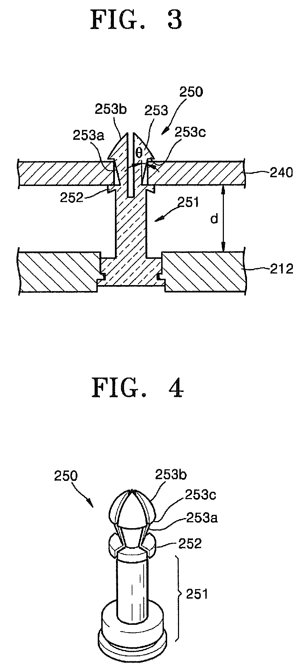

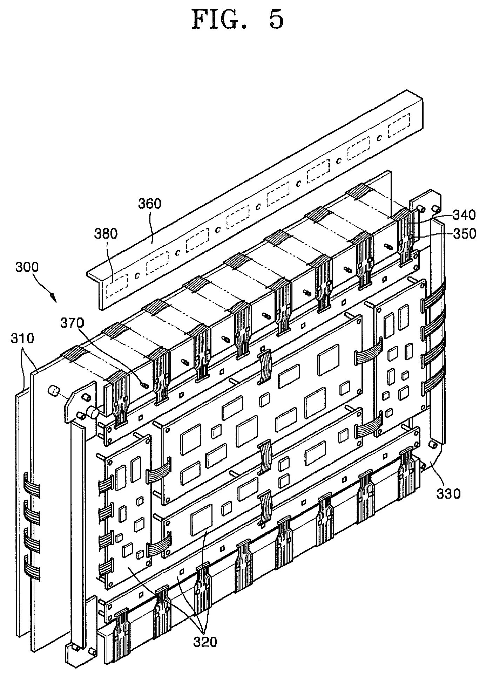

FIG. 3 is a cross-sectional view taken along line III-III of FIG. 2, and FIG. 4 is a perspective view of the connecting member 250 before being forcibly inserted into the chassis 210 according to an embodiment of the present invention. Referring to FIGS. 3 and 4, the connecting member 250 includes a center portion 251, a wing portion 252, and a head portion 253.

The center portion 251 is formed on an axis of the connecting member 250. A bottom portion of the center portion 251 has a hollow cylindrical shape and may be forcibly inserted into the bending portion 212 from a side of the bending portion 212 opposite the cover plate 240 . The upper portion of the center portion 251 is divided into four sections. Since a distance d between the cover plate 240 and the bending portion 212 can be determined according to a degree of forcible insertion of the center portion 251 into the bending portion 212, a designer can determine the degree of forcible insertion of the center portion 251 into the bending portion 212 based on thickness of the IC chips 230 and the chip heat-dissipating sheets 270.

The wing portion 252 is formed on an upper portion of the center portion 251, supports the cover plate 240, and fixes one side of the cover plate 240. The wing portion 252 extends from the center portion 251, and is also divided into four sections like the upper portion of the center portion 251.

The head portion 253 is formed on the upper portion of the wing portion 252, inserted into the fixing holes 241 for fixing the cover plate 240, and divided into four sections like the upper portion of the center portion 251 and the wing portion 252.

The head portion 253 includes a tapered portion for fixing the cover plate 240. The tapered portion of the head portion 253 is divided into a bottom tapered portion 253a and an upper tapered portion 253b. An engagement force varies according to a gradient θ of the bottom taper portion 253a. The greater the gradient θ , the stronger the engagement force. The smaller the gradient θ , the weaker the engagement force. Therefore, the designer determines the gradient θ of the bottom tapered portion 253a according to the degree of the engagement force as required.

A projection 253c is formed between the bottom tapered portion 253a and the upper tapered portion 253b of the head portion 253. The projection 253c prevents the cover plate 240 from being separated from the head portion 253 when an external shock is applied to the cover plate 240.

Accordingly, the center portion 251, the wing portion 252, and the head portion 253 are divided into four sections, respectively, however, such divisions are not limited to four, and can be divided into two, three, five or other sections. The center portion 251, the wing portion 252, and the head portion 253 may not divided if they are formed of an elastic material or an undivided head portion 253 can fix the cover plate 240.

An order of mounting the cover plate 240 will now be described. The connection members 250 are forcibly inserted into the bending portion 212 at predetermined intervals using a forcible insertion process.

The signal transmission members 220 and the IC chips 230 are formed on the bending portion 212 where the connection members 250 are not inserted. Then, the chip heat-dissipating sheets 270 are disposed on the IC chips 230.

The cover plate 240 having the fixing holes 241 is pressed onto the upper tapered portions 253a of the head portions 253 of the connection members 253. When the fixing holes 241 are engaged with the head portions 253, the cover plate 240 is retained by the bottom tapered portion 253a of the head portion 253, so that the cover plate 240 is easily fixed onto the connection members 250.

Referring to FIG. 3, in the mounting structure of the cover plate 240, the connection members 250 are used to maintain a constant distance d between the cover plate 240 and the bending portion 212, thereby preventing the IC chips 230 from being damaged due to movement of the cover plate 240.

Also, in the mounting structure of the cover plate 240, the engagement force of the cover plate 240 is determined according to the gradient θ of the bottom tapered portion 253a disposed in the head portion 253 of the connection members 250 so that the designer can control the engagement force of the connection members, as required by adjusting the gradient θ of the bottom tapered portion 253a so that engagement portions of the cover plate 240 maintain a constant engagement force.

Also, in the mounting structure of the cover plate 240, since the distance d between the cover plate 240 and the bending portion 212 and the engagement force do not change due to vibration of the chassis 210, although the connection members 250 are used for a long time, adherence between the chip heat-dissipating sheets 270 and the IC chips 230 does not change. Therefore, the heat-dissipating performance of the chip heat-dissipating sheets 270 is maintained.

FIG. 5 is a schematic perspective view of a plasma display module 300 including the mounting structure of the cover plate according to an embodiment of the present invention.

Referring to FIG. 5, the plasma display module 300 includes a plasma display panel 310 which displays images, a plurality of circuit boards 320 in which circuits for driving the plasma display panels 310 are disposed, and a chassis 330 that supports the plasma display panel 310 and the circuit boards 320.

Also, the plasma display module 300 includes signal transmission members 340 that electrically connect the circuit boards 320 and the plasma display panel 310, IC chips 350 that are mounted in the chassis 330 and connected to the signal transmission members 340, a cover plate 360 that protects the IC chips 350, and connection members 370.

The plasma display module 310 is connected to the chassis 330 via two-sided adhesive members 380 attached to a rear surface of the plasma display panel 310. A two-sided tape is used as the two-sided adhesive members 380.

A panel heat-dissipating sheet 390 having a good thermal conductivity is interposed between the plasma display panel 310 and the chassis 330 so that heat generated by the plasma display panel 310 during operation can be dissipated to the chassis 330.

The cover plate 360 and the connection members 370 have a same construction as the cover plate 240 and the connection members 250 described with respect to FIGS. 2, 3 and 4.

Therefore, the plasma display module 300 including the mounting structure of the cover plate mounts the cover plate 360 using the connection members 370 between the cover plate 360 and the chassis 330 at a regular interval, thereby protecting the IC chips 350 and effectively dissipating heat generated by the IC chips 350.

According to the embodiments of the present invention, connection members maintain a constant distance between a cover plate and a bending portion regardless of an engagement portion of the cover plate, thereby preventing IC chips from being damaged when the cover plate is mounted.

Also, according to the embodiments of the present invention, a designer can determine the shape of connection members having a constant engagement force, resulting in maintenance of a constant engagement force at every engagement portion.
Also, according to the present invention, connection members maintain a constant distance between the cover plate and a chassis so that a distance between the cover plate and the chassis and an engagement force does not change due to vibration of the chassis. Therefore, although connection members are used for a long time, the cover plate is not separated from the chassis, and the heat-dissipating performance of IC chips is not deteriorated.

## Claims

1. A mounting structure of a cover plate, the structure comprising:
a chassis;
an integrated circuit (IC) chip mounted on the chassis and connected to a signal transmission member;
a cover plate facing the IC chip and protecting the signal transmission member and the IC chip; and
a connection member comprising:
a center portion maintaining a constant distance between the cover plate and the chassis,
a wing portion supporting the cover plate, and
a head portion fixing the cover plate onto the chassis.

2. The structure of claim 1, wherein the signal transmission member is a tape carrier package (TCP).

3. The structure of one of the preceding claims, further comprising:
a chip heat-dissipating sheet interposed between the IC chips and the cover plate.

4. The structure of one of the preceding claims, wherein the head portion comprises a tapered portion fixing the cover plate.

5. The structure of one of the preceding claims, wherein the head portion comprises a projection preventing the cover plate from separating from the chassis.

6. The structure of one of the preceding claims, wherein the center portion, the wing portion, and the head portion of the connection member are divided into a plurality of portions.

7. The structure of one of the preceding claims, wherein the connection member has a first end engaging the chassis and a second end, the second end comprising:
a first tapered portion to guide the second end into the engagement hole,
a wing portion to engagingly support the cover plate, and
a second tapered portion to urge a side of the engagement hole toward the wing portion to maintain the cover plate at a predetermined distance from the chassis.

8. The structure of one of the preceding claims, wherein the first tapered portion comprises a plurality of tapered portions which elastically move in a first direction to guide the second end into the engagement hole.

9. The structure of one of the preceding claims, wherein the second tapered portion comprises a plurality of tapered portions which elastically move in the first direction to guide the second end into the engagement hole and elastically move in a second direction opposite the first direction to urge the side of the engagement hole toward the wing portion.

10. The structure of one of the preceding claims, further comprising:
a dissipating sheet disposed between the IC chip and the cover plate to transfer heat from the IC chip to the cover plate.

11. A plasma display module comprising:
a plasma display panel displaying an image;
a circuit board driving the plasma display panel;
a chassis supporting the plasma display panel and the circuit board;
a signal transmission member electrically connecting the circuit board to the plasma display panel;
an IC chip mounted on the chassis and connected to the signal transmission member;
a cover plate facing the IC chip and protecting the signal transmission member and the IC chip; and
a connection member comprising:
a center portion maintaining a constant distance between the cover plate and the chassis,
a wing portion supporting the cover plate, and
a head portion fixing the cover plate to the chassis.

12. The plasma display module of claim 11, wherein the signal transmission member is a TCP.

13. The plasma display module of one of the claims 11-12, further comprising: a chip heat-dissipating sheet interposed between the IC chip and the cover plate.

14. The plasma display module of one of the claims 11-13, wherein the head portion comprises a tapered portion for fixing the cover plate.

15. The plasma display module of one of the claims 11-14, wherein the head portion comprises a projection for preventing the cover plate from separating from the chassis.

16. The plasma display module of one of the claims 11-15, wherein the center portion, the wing portion, and the head portion of the connection member are divided into a plurality of portions.

17. The plasma display module of one of the claims 11-16, wherein the connection member has a first end engaging the chassis and a second end, the second end comprising:
a first tapered portion to guide the second end into the engagement hole,
a wing portion to engagingly support the cover plate, and
a second tapered portion to urge a side of the engagement hole toward the wing portion to maintain the cover plate at a predetermined distance from the chassis.

18. The plasma display module of claim 17, wherein the first tapered portion comprises a plurality of tapered portions which elastically move in a first direction to guide the second end into the engagement hole.

19. The plasma display module of one of the claims 17-18, wherein the second tapered portion comprises a plurality of tapered portions which elastically move in the first direction to guide the second end into the engagement hole and elastically move in a second direction opposite the first direction to urge the side of the engagement hole toward the wing portion.

20. The plasma display module of one of the claims 17-19, further comprising:
a dissipating sheet disposed between the IC chip and the cover plate to transfer heat from the IC chip to the cover plate.
